# FASCICULE DE BREVET EUROPEEN

(11) **EP 4 458 118 B1**
(45) Date de publication et mention de la délivrance du brevet: **11.02.2026**
(21) Numéro de dépôt: 22840226.9
(22) Date de dépôt: 30.12.2022
(51) Int. Cl.: H10N 69/00, H10N 60/12, G01R 29/08, G01R 33/035

(54) **DISPOSITIF PRÉSENTANT UN RÉSEAU DE JONCTIONS JOSEPHSON À DISTRIBUTION DE COURANT HOMOGÈNE**
VORRICHTUNG MIT EINER GRUPPE VON JOSEPHSON-ÜBERGÄNGEN MIT HOMOGENER STROMVERTEILUNG
DEVICE COMPRISING AN ARRAY OF JOSEPHSON JUNCTIONS WITH HOMOGENEOUS CURRENT DISTRIBUTION

(30) Priorité: 31.12.2021 FR 2114747
(43) Date de publication de la demande: 06.11.2024
(73) Titulaire: THALES, 92400 Courbevoie (FR); Centre National de la Recherche Scientifique, 75016 Paris (FR)
(72) Inventeur: CRETE, Denis, 91767 PALAISEAU (FR)
(74) Mandataire: Lavoix
(86) Numéro de dépôt international: PCT/EP2022/088070
(87) Numéro de publication internationale: WO 2023/126515

(56) Documents cités:
- US-B1- 6 690 162
- CRÉTÉ D ET AL: "Effect of self-induced flux in parallel arrays of Josephson junctions", 2019 IEEE INTERNATIONAL SUPERCONDUCTIVE ELECTRONICS CONFERENCE, RIVERSIDE, CA, 28 JULY-1 AUGUST 2019, 28 July 2019 (2019-07-28), XP033710832, DOI: 10.1109/ISEC46533.2019.8990895
- SCHULER J ET AL: "Comparison of Josephson vortex flow transistors with different gate line configurations", APPLIED PHYSICS LETTERS, vol. 78, no. 8, 19 February 2001 (2001-02-19), pages 1095 - 1097, XP012028663, DOI: 10.1063/1.1346625

## Description

La présente invention concerne un dispositif supraconducteur, notamment un détecteur de champ électromagnétique ou un amplificateur.

La présente invention fait partie du domaine des circuits électroniques supraconducteurs à haute température critique.

Les circuits supraconducteurs à base de jonctions Josephson ont un très faible niveau de bruit, et sont, notamment en tant que détecteurs de champ électromagnétique, très sensibles.

Pour augmenter leurs performances, des réseaux contenant un grand nombre de jonctions Josephson sont généralement utilisés. Les réseaux ont une structure unidimensionnelle (série ou parallèle) ou bidimensionnelle. Des structures tridimensionnelles ont même été proposées.

Les structures unidimensionnelles de type série ont une longueur limitée par l'impédance totale du dispositif, qui doit rester basse pour avoir une bonne adaptation en sortie (et donc une bande passante large).

Une solution à ce problème est de mettre des éléments en parallèle et il est ainsi obtenu des réseaux de structure unidimensionnelle de type parallèle ou encore des réseaux bidimensionnels.

Dans les deux cas, la largeur (dimension perpendiculaire à la longueur) est limitée car les courants de polarisation sont essentiellement concentrés sur les deux bords du réseau.

La situation est un peu comparable à une distribution de courant radiofréquence (RF) dans un conducteur métallique, mais ici cette distribution est contrôlée par l'effet Meissner. Au-delà d'une dimension caractéristique, les jonctions placées au centre du réseau ne reçoivent pas assez de courant de polarisation pour participer activement à la réponse du dispositif.

Il existe même des situations où ces jonctions détruisent la réponse des jonctions situées sur les bords du réseau.

Dans le cadre du développement de tels réseaux en technologie supraconductrice à basse température critique, cette problématique est résolue en employant un réseau de résistances et un plan de masse supraconducteur.

Toutefois, la technologie des supraconducteurs à haute température critique ne permet pas d'intégrer des résistances et les structures à plusieurs couches supraconductrices sont difficilement réalisables.

Des dispositifs supraconducteurs sont également connus d'un article de D. Crété et al. intitulé « Effect of self-induced flux in parallel arrays of Josephson arrays », d'un article de J. Schuler et al. intitulé « Comparison of Josephson vortex flow transistors with different gate line configuration » et du document US 6 690 192 B1.

Il existe donc un besoin pour un dispositif supraconducteur réalisé par un circuit à base de jonctions Josephson de taille relativement grande présentant une distribution de courant plus homogène.

A cet effet, la description décrit un dispositif supraconducteur, notamment détecteur de champ électromagnétique, antenne ou amplificateur, le dispositif comprenant un réseau de jonctions Josephson en parallèle, un premier plan et une largeur étant définis pour le réseau, au moins une bande conductrice contenue dans un deuxième plan, le deuxième plan faisant face au premier plan, la ou chaque bande conductrice étant réalisée en or, en aluminium, en cuivre, en palladium, en un alliage des éléments précités, en Ta₂N ou en cuprate, la ou chaque bande conductrice étant, de préférence, reliée pour former une grille conductrice. Le dispositif supraconducteur comporte une unité d'alimentation propre à alimenter les jonctions Josephson du réseau de jonctions Josephson et la ou chaque bande conductrice avec des courants de signes opposés, l'unité d'alimentation alimentant les jonctions Josephson du réseau de jonctions Josephson et la ou chaque bande conductrice avec des courants ayant une intensité choisie pour que le total des courants circulant dans la ou chaque bande conductrice soit égal au courant circulant dans le réseau de jonctions Josephson à 10% près, le premier plan et le deuxième plan étant agencés pour que chaque bande conductrice soit à une distance d'une jonction Josephson inférieure ou égale à 40% de la largeur définie pour le réseau.

Il apparaît ainsi que le dispositif supraconducteur permet de répartir le courant presque uniformément dans un circuit de grandes dimensions transverses par rapport à la direction du courant de polarisation.

Selon des modes de réalisation particuliers, le dispositif supraconducteur présente une ou plusieurs des caractéristiques suivantes, prise(s) isolément ou selon toutes les combinaisons techniquement possibles :
- la ou les bandes conductrices sont agencées pour être chacune à une distance d'une jonction Josephson inférieure ou égale à 5% de la largeur définie pour le réseau.
- les jonctions Josephson comportent un matériau supraconducteur présentant une température critique supérieure à 40 Kelvins.
- le réseau de jonctions Josephson est positionné sur un premier substrat et les bandes conductrices sont positionnées sur un deuxième substrat, les deux substrats se faisant face.
- le réseau de jonctions Josephson est positionné sur un premier substrat et les bandes conductrices sont positionnées sur un deuxième substrat, les bandes conductrices étant espacées du réseau de jonctions Josephson par au moins un des substrats.
- chaque bande conductrice présente une largeur comprise entre 3 micromètres et la largeur définie pour le réseau.
- la ou les bandes conductrices forment un autre réseau de jonctions Josephson.
- le dispositif comporte une couche d'espacement insérée entre le premier plan et le deuxième plan.
- la couche d'espacement est réalisée en un matériau isolant.
- une distance moyenne entre deux jonctions Josephson du réseau est définie, le premier plan et le deuxième plan sont agencés pour que chaque bande conductrice soit à une distance d'une jonction Josephson supérieure ou égale à la distance moyenne entre deux jonctions Josephson du réseau.

Des caractéristiques et avantages de l'invention apparaîtront à la lecture de la description qui va suivre, donnée uniquement à titre d'exemple non limitatif, et faite en référence aux dessins annexés, sur lesquels :
- la figure 1 est une vue schématique en perspective d'un premier exemple de détecteur de champ magnétique comportant des supraconducteurs,
- la figure 2 est une représentation schématique en section du détecteur de la figure 1,
- la figure 3 est une représentation schématique en section d'un deuxième exemple de détecteur,
- la figure 4 est une représentation schématique en section d'un troisième exemple de détecteur,
- la figure 5 est une représentation schématique en section d'un quatrième exemple de détecteur,
- la figure 6 est une représentation schématique en section d'un cinquième exemple de détecteur, et
- la figure 7 est une représentation schématique en section d'un sixième exemple de détecteur.

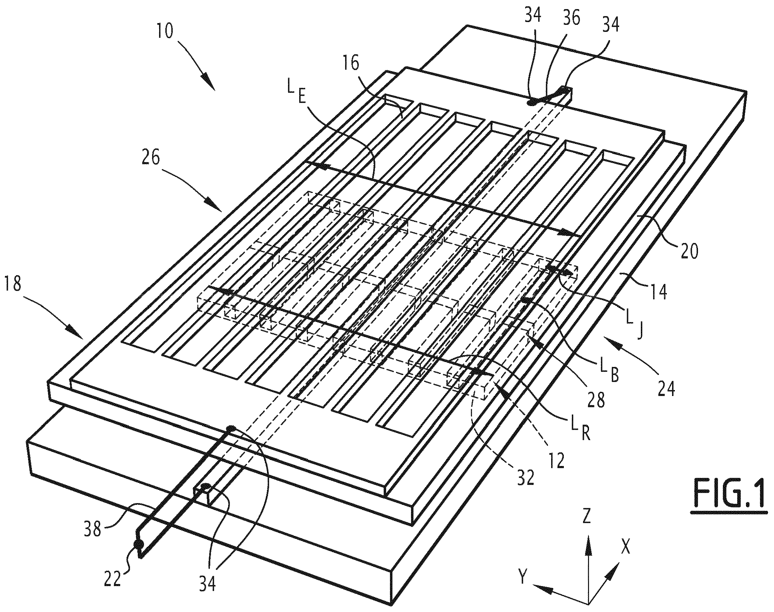

Un détecteur 10 de champ magnétique est représenté sur la figure 1.

Le détecteur 10 comporte un réseau 12 positionné sur un premier substrat 14, des bandes conductrices 16 formant un ensemble 18 positionné sur un deuxième substrat 20 et une unité d'alimentation 22.

Le réseau 12 et le premier substrat 14 forment une première puce 24 alors que l'ensemble 18 des bandes conductrices 16 et du deuxième substrat 20 forment une deuxième puce 26.

Le réseau 12 est un réseau de jonctions Josephson 28.

Une jonction Josephson 28 est un ensemble formé par deux supraconducteurs couplés par une barrière, la barrière étant formée, par exemple, par une couche d'un matériau isolant ou par une couche d'un matériau non-supraconducteur.

Selon l'exemple de la figure 1, les jonctions Josephson 28 comportent un matériau supraconducteur présentant une température critique supérieure à 40 Kelvins.

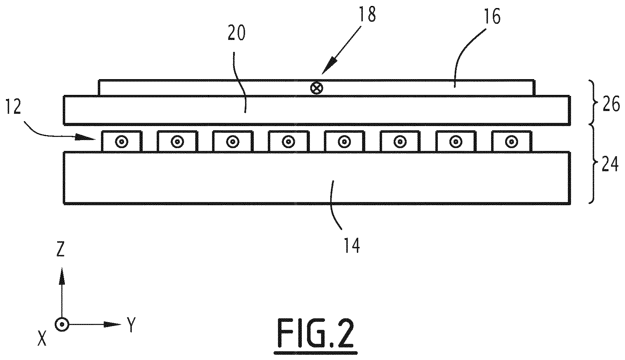

Dans la représentation de la figure 2, il apparaît que le réseau 12 comporte huit jonctions Josephson 28, ce nombre étant choisi à titre d'illustration.

Les huit jonctions Josephson 28 sont visibles par transparence du deuxième substrat 20.

Les jonctions Josephson 28 sont connectées en parallèle par des branches s'étendant le long d'une direction longitudinale X.

Par ailleurs, les branches sont reliées ensemble par des portions de connexion 32 s'étendant le long d'une première direction transverse Y.

La direction longitudinale X et la première direction transverse Y permettent de définir un plan pour le réseau 12 de jonctions Josephson 28, dit premier plan P1.

Une direction perpendiculaire au premier plan P1 peut également être définie, cette direction étant dénommée deuxième direction transverse Z.

Une largeur L_{R} est également définie pour le réseau 12.

La largeur L_{R} est la dimension du réseau 12 le long de la première direction transverse Y.

Plus précisément, la largeur L_{R} est la distance la plus grande entre deux jonctions Josephson 28, la distance étant mesurée le long de la première direction transverse Y.

Dès lors, la largeur L_{R} du réseau 12 est la somme de l'ensemble des largeurs L_{J} des jonctions Josephson 28 et de l'ensemble des espaces inter-jonctions Josephson 28.

A titre d'exemple, si le matériau supraconducteur est réalisé avec du matériau YBa₂Cu₃O₇₋ₓ (avec x variant entre 0 et 1), le premier substrat 14 est réalisé avec un matériau choisi de façon non-limitative parmi le saphir, le MgO, ou le NdGaO₃.

Chaque bande conductrice 16 s'étend principalement selon la direction longitudinale X.

En outre, chaque bande conductrice 16 présente une dimension selon la première direction longitudinale Y, dénommée largeur L_{B}, qui est typiquement supérieure à 3 micromètres.

Les bandes conductrices 16 sont parallèles entre elles.

Les bandes conductrices 16 sont agencées selon un deuxième plan P2.

En l'espèce, le deuxième plan P2 est parallèle au premier plan P1.

Selon l'exemple décrit, les bandes 16 sont réalisées en or.

En variante, la bande 16 est réalisée en aluminium, en cuivre, ou en palladium.

Les alliages des éléments précités peuvent également être envisagés.

Il est également défini une largeur L_{E} pour l'ensemble 18 formé par les bandes conductrices 16.

Similairement au cas du réseau 12, la largeur L_{E} de l'ensemble 18 est la dimension de l'ensemble 18 le long de la première direction transverse Y.

Plus précisément, la largeur L_{E} de l'ensemble 18 est la distance la plus grande entre deux bandes conductrices 16, la distance étant mesurée le long de la première direction transverse Y. Plus précisément, la largeur des bandes conductrices extrêmes 16 étant prise en compte, la largeur L_{E} de l'ensemble 18 est la distance la plus grande entre deux points de deux bandes conductrices 16.

Dans le présent exemple, la largeur L_{R} du réseau 12 et la largeur L_{E} de l'ensemble 18 sont égales entre elles à 5% près.

Il est à noter qu'il est envisageable que l'ensemble 18 comporte une unique bande 16, de sorte que dans ce cas, la largeur de la bande 16 sera égale à la largeur L_{E} de l'ensemble 18.

Cela signifie que, dans tous les modes de réalisation, la ou chaque bande 16 présente une largeur comprise entre 3 micromètres (µm) et la largeur L_{E} de l'ensemble 18.

En ce qui concerne le deuxième substrat 20, une grande variété de matériaux peut être utilisée, notamment un substrat à faibles pertes dans le domaine radiofréquence comme le silicium. Les matériaux cités pour le premier substrat 14 peuvent également être envisagés.

Le maintien des puces est assuré par collage. Notamment, une colle en nonadécane ou en apiezon N peut être envisagée pour réaliser un tel collage.

En variante, le maintien des deux puces est réalisé par un assemblage mécanique. L'unité d'alimentation 22 est généralement un générateur de courant.

L'unité d'alimentation 22 est propre à alimenter les jonctions Josephson 28 et les bandes conductrices 16 avec des courants de signes opposés.

Selon l'exemple décrit, cela signifie que le courant circule dans un premier sens le long de la direction longitudinale X et dans un deuxième sens le long de la direction longitudinale X, le deuxième sens étant opposé au premier sens.

En outre, l'unité d'alimentation 22 est propre à générer des courants respectant aussi une condition d'amplitude, à savoir que le total des courants circulant dans la ou chaque bande conductrice 16 est égal au courant circulant dans le réseau 12 de jonctions Josephson 28 à 10% près.

Les contacts électriques 34 entre les différentes puces 24 et 26 sont schématisés par des ellipses. Les deux contacts 34 représentés par les ellipses situées en arrière-plan sont reliés entre eux par un fil 36 alors que les deux contacts 34 représentés par les ellipses situées dans le premier plan sont les points de branchement de l'unité d'alimentation 22.

Les fils 36 de liaison entre les deux puces 24 et 26 et ceux des amenées de courant 38 peuvent être réalisés en or.

Le premier plan et le deuxième plan sont agencés pour que chaque bande conductrice 16 soit à une distance d'une jonction Josephson 28 inférieure ou égale à 40% de la largeur définie pour le réseau 12.

Cela signifie que si le réseau 12 est déjà présent, les différentes bandes conductrices 16 vont être agencées (par rapport au dit réseau 12) pour respecter la condition de distance précitée.

Plusieurs agencements peuvent être envisagés.

Dans l'exemple décrit et comme visible sur la figure 2, les bandes conductrices 16 sont espacées du réseau 12 de jonctions Josephson 28 par au moins un des substrats.

Autrement formulé, les bandes conductrices 16 sont espacées du réseau 12 par un espace comprenant le deuxième substrat 20.

Un tel agencement correspond à un agencement dit « piggy back » qui signifie « monté sur le dos » ou « superposé » et correspond à une configuration l'un sur l'autre.

Dans un tel cas, les largeurs typiques sont de l'ordre de quelques centaines de micromètres. Aussi, selon les cas, la largeur est comprise entre 0,1 millimètre (mm) et 2 mm.

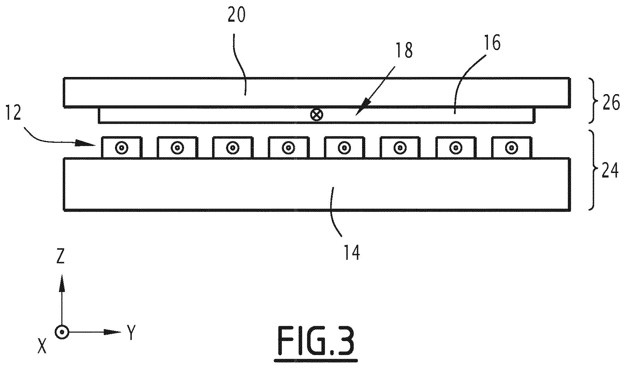

Un autre exemple est proposé à la figure 3.

Dans cet exemple, le réseau 12 et les bandes conductrices 16 se font face.

Une telle configuration correspond à un agencement dit « flip-chip » qui signifie littéralement « puce retournée ».

Dans un tel cas, les largeurs typiques sont de l'ordre de quelques dizaines de micromètres, notamment comprises entre 20 µm et 2 mm.

En variante, en appelant « premier réseau 12 de jonctions Josephson 28 » le réseau 12 de jonctions Josephson 28, les bandes conductrices 16 forment un deuxième réseau de jonctions Josephson.

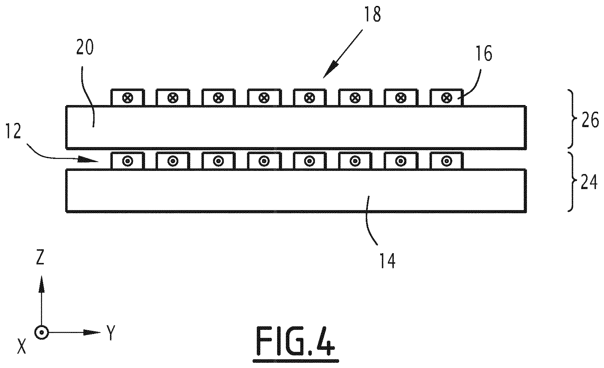

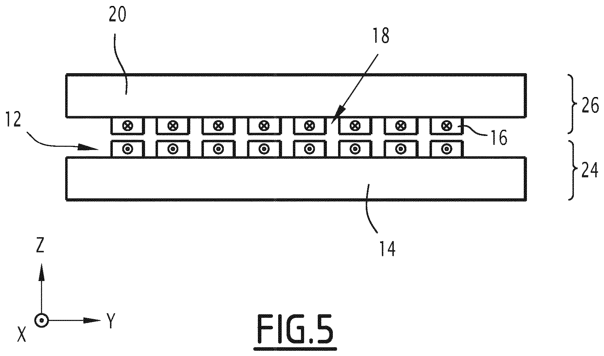

Deux exemples sont présentés aux figures 4 et 5, où au moins l'une des 2 puces contient un réseau de jonctions Josephson.

Dans chacun des cas, à titre d'illustration, les deux réseaux de jonctions Josephson comportent le même nombre de jonctions Josephson.

La figure 4 illustre le cas d'une configuration piggy-back dans laquelle le deuxième réseau de jonctions Josephson est espacé du premier réseau 12 de jonctions Josephson 28 par le deuxième substrat 20.

A contrario, la figure 5 illustre le cas d'une configuration flip-chip dans laquelle le deuxième réseau de jonctions Josephson est en face du premier réseau 12 de jonctions Josephson 28.

Dans ces modes de réalisations, la bande 16 est réalisée en un matériau supraconducteur comme du cuprate.

Selon un autre exemple, la bande 16 est réalisée en Ta₂N.

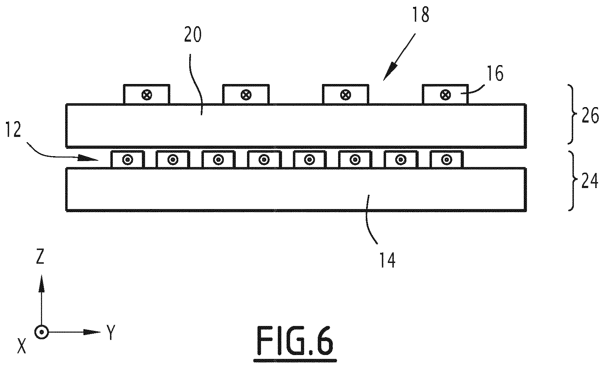

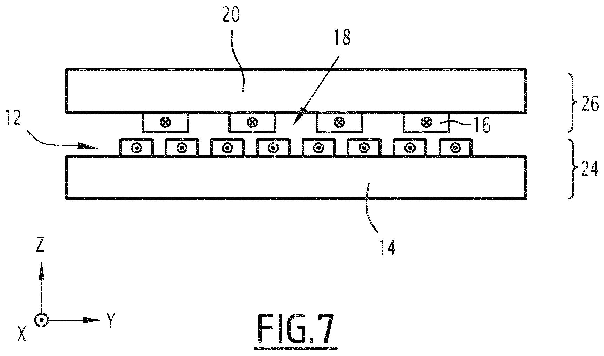

Selon une autre variante, les bandes conductrices 16 forment une grille comme représenté très schématiquement sur les figures 6 et 7.

Les figures 6 et 7 correspondent respectivement aux cas d'une configuration piggy-back et d'une configuration flip-chip.

Dans chacun des cas, le nombre de bandes conductrices 16 est égal à 5.

De ce fait, il apparaît que les bandes conductrices 16 peuvent ne pas être alignées avec les jonctions Josephson 28 du réseau 12 pour obtenir l'effet d'homogénéisation du courant. Seule la condition précitée de distance est à prendre en compte.

Il peut être noté que l'effet d'homogénéisation réapparaît dès que d₁₂<d_{z}< 40%.L_{R}, en notant d₁₂ la distance moyenne entre deux jonctions Josephson 28 du réseau 12, et dz la distance entre les deux plans P1 et P2.

Dans la plupart des cas, la distance entre deux jonctions Josephson 28 adjacentes du réseau 12 est la même pour toute paire de jonctions Josephson 28 adjacentes mais lorsque ce n'est pas le cas, la distance moyenne est, par exemple, la moyenne arithmétique des distances entre les jonctions Josephson 28 du réseau 12.

Par ailleurs, chacune des bandes 16 de la grille peut être adaptée pour contrôler le courant qui la parcourt et avoir un contrôle du champ magnétique au niveau du réseau 12 de jonctions Josephson 28. Ceci pourrait permettre une correction au second ordre des effets de bord ou encore de générer une distribution de courant qui ne soit pas nécessairement uniforme.

L'ensemble des configurations présentées concerne des cas où le deuxième substrat 20 est en haut alors que le premier substrat 14 est en bas.

L'inverse est également possible et les mêmes remarques que précédemment sont valables.

En outre, il convient de noter que ces configurations rendent aussi possible un rapprochement des bandes conductrices 16 des jonctions Josephson 28. Ainsi, selon un cas particulier, les bandes conductrices 16 sont agencées pour être chacune à une distance d'une jonction Josephson 28 inférieure ou égale à 5% de la largeur définie pour le réseau 12.

Un tel agencement relatif des bandes conductrices 16 et du réseau 12 de jonctions Josephson 28 (distance inférieure à 40% de la largeur du réseau 12) permet d'obtenir une distribution de courant de polarisation plus homogène sur l'ensemble du réseau 12.

Pour bien comprendre cet effet, il convient de noter qu'il existe une analogie entre les lignes de transmissions de signaux radiofréquences et les bandes supraconductrices : l'effet de peau et l'effet Meissner induisent tous les deux des distributions de courant non uniformes, très similaires.

Il est observé dans le cas des lignes de transmissions radiofréquences que la structure microruban (plus souvent dénommée microstrip) est la structure qui assure la répartition du courant radiofréquence la plus homogène sur la largeur de la ligne grâce à la présence du plan de masse.

Cette analogie permet de prévoir qu'une structure formée de deux bandes superposées, en influence mutuelle, présente une distribution de courant plus homogène.

Plus précisément, tout comme le champ électrique est uniforme entre les deux électrodes d'un condensateur plan (grâce à la condition d'annulation du champ électrique à l'intérieur des électrodes métalliques), le champ magnétique sera uniforme entre les deux bandes supraconductrices grâce à l'effet Meissner qui impose que le champ magnétique soit nul à l'intérieur des supraconducteurs. D'après les équations de Maxwell, la densité de courant circulant à la surface des supraconducteurs est alors uniforme.

Les expériences de la demanderesse ont montré que cet effet est même capable de contrôler la distribution de courant dans une bande supraconductrice lorsque les bandes sont parcourues par des intensités égales mais opposées.

La demanderesse a alors observé que lorsque la distance d séparant les deux bandes est petite devant leur largeur, la distribution de courant dans une bande inférieure, qui serait notablement plus large que la bande supérieure, est quasiment nulle à grande distance de la bande supérieure (selon l'axe Y).

En outre, la distribution de courant dans la bande inférieure est essentiellement constante dans la partie centrale. C'est ce principe qui est utilisé dans les différentes implémentations du détecteur.

Si la bande supérieure n'est pas supraconductrice, mais juste conductrice, les expériences de la demanderesse ont montré que le résultat est essentiellement le même pour la bande inférieure (qui reste supraconductrice).

Ainsi, du fait que la condition de distance précitée est respectée, le détecteur 10 proposé permet d'obtenir une plus grande homogénéité des courants de polarisation pour un réseau 12 de jonctions Josephson 28 de grande taille, donc par là une réponse améliorée.

De fait, en l'absence des bandes, la réponse d'un détecteur 10 passe par un maximum en fonction de la largeur du réseau 12, avant de s'effondrer. Avec les bandes 16, il est possible que la réponse du détecteur 10 reste proportionnelle à la largeur du réseau 12 de jonctions Josephson 28 bien au-delà de 20 µm qui correspond à la largeur optimale observée dans les solutions de l'état de la technique.

Cela implique que le gain en sensibilité pour la réponse du détecteur 10 pour un réseau 12 de jonctions Josephson 28 de largeur 100 µm sera d'un facteur 5 environ. Comme le gain est proportionnel à la largeur des réseaux utilisés, il sera d'un facteur 15 environ pour un réseau 12 de jonctions Josephson 28 de largeur 300 µm.

Cela ouvre ainsi la voie à des réseaux de très grande taille, qui ne seront plus limités que par la longueur d'onde des signaux (de l'ordre du mètre en ultra haute-fréquence).

En outre, le détecteur 10 proposé est simple dans la mesure où cela n'implique pas d'utiliser une technologie à plusieurs couches supraconductrices ou un réseau de résistances de distribution du courant. Une telle simplicité permet d'utiliser un tel détecteur 10 même avec les contraintes d'un circuit comprenant des jonctions Josephson 28 avec des matériaux supraconducteurs à haute température critique.

En outre, les bandes conductrices 16 et le réseau 12 pouvant être disposés sur des substrats différents, il est possible d'utiliser des assemblages de type flip-chip ou piggy-back.

Les réalisations en flip-chip correspondant aux figures 3, 5 et 7 peuvent impliquer l'emploi d'une couche isolante pour éviter que les deux circuits (réseau 12 et ensemble 18 des bandes conductrices 16) en vis-à-vis ne viennent en contact électrique. Une telle couche isolante sera alors prise en sandwich entre les deux puces.

L'épaisseur de cette couche n'est pas critique ; selon la technologie utilisée pour la jonction Josephson, il peut exister des contraintes supplémentaires/différentes. Par exemple, avec des jonctions Josephson à barrière irradiée, le choix le plus critique porte sur la contrainte de ne pas chauffer le circuit supraconducteur à haute température critique plus de 10 minutes au-dessus de 80°C. Il est possible d'utiliser une résine du même type que pour les opérations de photolithogravure. Un dépôt à froid de SiOₓ (où x peut varier entre 1 et 2) peut convenir également.

Lorsque la technologie de flip-chip utilise des billes d'or déposées par soudure à ultrasons, procédé dit de « ball bonding », la taille des billes (de plusieurs dizaines de micromètres) suffit à assurer une séparation suffisante des deux circuits. Il n'est alors pas nécessaire d'avoir recours à une couche d'isolant supplémentaire.

Les réalisations en piggy-back n'ont pas cette problématique.

La présence de la couche additionnelle n'empêche pas que chacun de ces assemblages soit compatible avec la technologie de fabrication des matériaux supraconducteurs à haute température critique.

Dans le cas où les bandes conductrices 16 forment un deuxième réseau de jonctions Josephson, cela permet que chaque réseau soit sur un substrat respectif, et de gagner un facteur 2 dans la réponse du détecteur 10.

Il peut d'ailleurs être noté que les réseaux 12 et/ou les bandes conductrices 16 peuvent non seulement être des réseaux de jonctions Josephson mais également des réseaux bidimensionnels.

Au final, le détecteur 10 qui vient d'être décrit est un détecteur de champ magnétique combinant sensibilité, large bande (du continu jusqu'à 10 GigaHertz) et dynamique.

Il peut être noté que cette homogénéité de la répartition du courant peut également être utilisée pour d'autres dispositifs supraconducteurs 10.

Ainsi, le dispositif 10 peut détecter d'autres éléments qu'un champ magnétique. En particulier, le dispositif 10 détecte également des ondes électromagnétiques.

Cela signifie que le dispositif 10 est, selon un mode de réalisation, un récepteur d'ondes radiofréquence.

Dans d'autres modes de réalisation, le dispositif 10 est un détecteur d'anomalies magnétiques.

En variante, le dispositif 10 est une antenne. L'antenne est alors de petite taille et combine sensibilité et large bande.

Selon une autre variante, le dispositif 10 est un amplificateur, cet amplificateur étant un amplificateur de faible bruit, faible dissipation de puissance et large bande.

## Revendications

1. Dispositif (10) supraconducteur, notamment détecteur (10) de champ électromagnétique, antenne ou amplificateur, le dispositif (10) comprenant :
- un réseau (12) de jonctions Josephson (28) en parallèle, un premier plan et une largeur (L_{R}) étant définis pour le réseau (12),
- au moins une bande conductrice (16) contenue dans un deuxième plan, le deuxième plan faisant face au premier plan, la ou chaque bande conductrice (16) étant réalisée en or, en aluminium, en cuivre, en palladium, en un alliage des éléments précités, en Ta₂N ou en cuprate, la ou chaque bande (16) conductrice étant, de préférence, reliée pour former une grille conductrice, et
- une unité d'alimentation (22) propre à alimenter les jonctions Josephson (28) du réseau (12) de jonctions Josephson (28) et la ou chaque bande conductrice (16) avec des courants de signes opposés, l'unité d'alimentation (22) alimentant les jonctions Josephson (28) du réseau (12) de jonctions Josephson (28) et la ou chaque bande conductrice (16) avec des courants ayant une intensité choisie pour que le total des courants circulant dans la ou chaque bande conductrice (16) soit égal au courant circulant dans le réseau (12) de jonctions Josephson (28) à 10% près,
le dispositif (10) supraconducteur étant **caractérisé en ce que** le premier plan et le deuxième plan sont agencés pour que chaque bande conductrice (16) soit à une distance d'une jonction Josephson (28) inférieure ou égale à 40% de la largeur définie pour le réseau (12).

2. Dispositif supraconducteur selon la revendication 1, dans lequel la ou les bandes conductrices (16) sont agencées pour être chacune à une distance d'une jonction Josephson (28) inférieure ou égale à 5% de la largeur (L_{R}) définie pour le réseau (12).

3. Dispositif supraconducteur selon la revendication 1 ou 2, dans lequel les jonctions Josephson (28) comportent un matériau supraconducteur présentant une température critique supérieure à 40 Kelvins.

4. Dispositif supraconducteur selon l'une quelconque des revendications 1 à 3, dans lequel le réseau (12) de jonctions Josephson (28) est positionné sur un premier substrat (14) et les bandes conductrices (16) sont positionnées sur un deuxième substrat (20), les deux substrats (14, 20) se faisant face.

5. Dispositif supraconducteur selon l'une quelconque des revendications 1 à 3, dans lequel le réseau (12) de jonctions Josephson (28) est positionné sur un premier substrat (14) et les bandes conductrices (16) sont positionnées sur un deuxième substrat (20), les bandes conductrices (16) étant espacées du réseau (12) de jonctions Josephson (28) par au moins un des substrats (14, 20).

6. Dispositif supraconducteur selon l'une quelconque des revendications 1 à 5, dans lequel chaque bande conductrice (16) présente une largeur (L_{B}) comprise entre 3 micromètres et la largeur définie pour le réseau (12).

7. Dispositif supraconducteur selon l'une quelconque des revendications 1 à 6, dans lequel la ou les bandes conductrices (16) forment un autre réseau de jonctions Josephson.

8. Dispositif supraconducteur selon l'une quelconque des revendications 1 à 7, dans lequel le dispositif (10) comporte une couche d'espacement insérée entre le premier plan et le deuxième plan.

9. Dispositif supraconducteur selon la revendication 8, dans lequel la couche d'espacement est réalisée en un matériau isolant.

10. Dispositif supraconducteur selon l'une quelconque des revendications 1 à 8, dans lequel une distance moyenne entre deux jonctions Josephson (28) du réseau (12) est définie, le premier plan et le deuxième plan sont agencés pour que chaque bande conductrice (16) soit à une distance d'une jonction Josephson (28) supérieure ou égale à la distance moyenne entre deux jonctions Josephson (28) du réseau (12).

## Patentansprüche

1. Supraleitende Vorrichtung (10), insbesondere Detektor (10) eines elektromagnetischen Felds, Antenne oder Verstärker, wobei die Vorrichtung (10) Folgendes umfasst:
- ein Netzwerk (12) von parallelen Josephson-Übergängen (28), wobei eine erste Ebene und eine Breite (L_{R}) für das Netzwerkdefiniert sind,
- mindestens einen leitfähigen Streifen (16), der in einer zweiten Ebene enthalten ist, wobei die zweite Ebene der ersten Ebene gegenüber liegt, wobei der oder jeder leitfähige Streifen (16) aus Gold, Aluminium, Kupfer, Palladium, einer Legierung der vorgenannten Elemente, Ta₂N oder Cuprat hergestellt ist, wobei der oder jeder leitfähige Streifen (16) vorzugsweise verbunden sind, um ein leitfähiges Gitter zu bilden, und
- ein Netzteil (22), das geeignet ist, die Josephson-Übergänge (28) des Netzwerkes (12) von Josephson-Übergängen (28) und den oder jeden leitfähigen Streifen (16) mit Strömen entgegengesetzter Vorzeichen zu versorgen, wobei das Netzteil (22) die Josephson-Übergänge (28) des Netzwerkes (12) von Josephson-Übergängen (28) und den oder jeden leitfähigen Streifen (16) mit Strömen einer Intensität versorgt, die so gewählt ist, dass die Gesamtheit der Ströme, die in dem oder jedem leitfähigen Streifen (16) fließen, gleich dem Strom ist, der in dem Netzwerk(12) von Josephson-Übergängen (28) im Bereich von 10 % beträgt,
wobei die supraleitende Vorrichtung (10) **dadurch gekennzeichnet ist, dass** die erste Ebene und die zweite Ebene so angeordnet sind, dass sich jeder leitfähige Streifen (16) in einem Abstand von einem Josephson-Übergang (28) befindet, der kleiner als oder gleich wie 40 % der Breite ist, die für das Netzwerk (12) definiert ist.

2. Supraleitende Vorrichtung nach Anspruch 1, wobei der oder die leitfähigen Streifen (16) so angeordnet sind, dass sie jeweils in einem Abstand von einem Josephson-Übergang (28) von weniger als oder gleich wie 5 % der Breite (L_{R}) sind, die für das Netzwerk (12) definiert ist.

3. Supraleitende Vorrichtung nach Anspruch 1 oder 2, wobei die Josephson-Übergänge (28) ein supraleitendes Material umfassen, das eine kritische Temperatur von mehr als 40 Kelvin aufweist.

4. Supraleitende Vorrichtung nach einem der Ansprüche 1 bis 3, wobei das Netzwerk(12) von Josephson-Übergängen (28) auf einem ersten Substrat (14) positioniert ist und die leitfähigen Streifen (16) auf einem zweiten Substrat (20) positioniert sind, wobei die zwei Substrate (14, 20) einander gegenüber liegen.

5. Supraleitende Vorrichtung nach einem der Ansprüche 1 bis 3, wobei die Gruppe (12) von Josephson-Übergängen (28) auf einem ersten Substrat (14) positioniert ist und die leitfähigen Streifen (16) auf einem zweiten Substrat (20) positioniert sind, wobei die leitfähigen Streifen (16) von der Gruppe (12) von Josephson-Übergängen (28) durch mindestens eines der Substrate (14, 20) beabstandet sind.

6. Supraleitende Vorrichtung nach einem der Ansprüche 1 bis 5, wobei jeder leitfähige Streifen (16) eine Breite (L_{B}) aufweist, die im Bereich zwischen 3 Mikrometern und der Breite liegt, die für das Netzwerk (12) definiert ist.

7. Supraleitende Vorrichtung nach einem der Ansprüche 1 bis 6, wobei der oder die leitfähigen Streifen (16) ein weiteres Netzwerk von Josephson-Übergängen bilden.

8. Supraleitende Vorrichtung nach einem der Ansprüche 1 bis 7, wobei die Vorrichtung (10) eine Abstandsschicht umfasst, die zwischen der ersten Ebene und der zweiten Ebene eingefügt ist.

9. Supraleitende Vorrichtung nach Anspruch 8, wobei die Abstandsschicht aus einem isolierenden Material hergestellt ist.

10. Supraleitende Vorrichtung nach einem der Ansprüche 1 bis 8, wobei ein mittlerer Abstand zwischen zwei Josephson-Übergängen (28) des Netzwerkes (12) definiert ist, die erste Ebene und die zweite Ebene so angeordnet sind, dass sich jeder leitfähige Streifen (16) in einem Abstand von einem Josephson-Übergang (28) befindet, der größer als oder gleich wie der mittlere Abstand zwischen zwei Josephson-Übergängen (28) des Netzwerkes (12) ist.

## Claims

1. A superconducting device (10), notably an electromagnetic field detector (10), antenna, or amplifier, the device (10) comprising:
- a network (12) of Josephson junctions (28) in parallel, a first plane and a width (L_{R}) being defined for the network (12),
- at least one conductive strip (16) contained in a second plane, the second plane facing the first plane, the or each conductive strip (16) being realized in gold, aluminum, copper, palladium, an alloy of the aforementioned elements, Ta₂N, or cuprate, the or each conductive strip (16), preferably, being connected to form a conductive grid, and
- a power supply unit (22) able to supply the Josephson junctions (28) of the network (12) of Josephson junctions (28) and the or each conductive strip (16) with currents of opposite signs, the power supply unit (22) supplying the Josephson junctions (28) of the network (12) of Josephson junctions (28) and the or each conductive strip (16) with currents having an intensity chosen so that the total currents flowing in the or each conductive strip (16) are equal to the current flowing in the network (12) of Josephson junctions (28) within 10%,
the superconducting device (10) being **characterized in that** the first plane and the second plane are arranged so that each conductive strip (16) is at a distance from a Josephson junction (28) less than or equal to 40% of the width defined for the network (12).

2. The superconducting device according to claim 1, wherein the conductive strips (16) are arranged to be each at a distance from a Josephson junction (28) less than or equal to 5% of the width (L_{R}) defined for the network (12).

3. The superconducting device according to claim 1 or 2, wherein the Josephson junctions (28) include a superconducting material presenting a critical temperature greater than 40 Kelvin.

4. The superconducting device according to any one of claims 1 to 3, wherein the network (12) of Josephson junctions (28) is positioned on a first substrate (14), and the conductive strips (16) are positioned on a second substrate (20), the two substrates (14, 20) facing each other.

5. The superconducting device according to any one of claims 1 to 3, wherein the network (12) of Josephson junctions (28) is positioned on a first substrate (14) and the conductive strips (16) are positioned on a second substrate (20), the conductive strips (16) being spaced from the network (12) of Josephson junctions (28) by at least one of the substrates (14, 20).

6. The superconducting device according to any one of claims 1 to 5, wherein each conductive strip (16) presents a width (L_{B}) between 3 micrometers and the width defined for the network (12).

7. The superconducting device according to any one of claims 1 to 6, wherein the conductive strip or strips (16) form another network of Josephson junctions.

8. The superconducting device according to any one of claims 1 to 7, wherein the device (10) includes a spacing layer inserted between the first plane and the second plane.

9. The superconducting device according to claim 8, wherein the spacing layer is made of an insulating material.

10. The superconducting device according to any one of claims 1 to 8, wherein an average distance between two Josephson junctions (28) of the network (12) is defined, the first plane and the second plane are arranged so that each conductive strip (16) is at a distance from a Josephson junction (28) greater than or equal to the average distance between two Josephson junctions (28) of the network (12).
